# EUROPÄISCHE PATENTSCHRIFT

(11) **EP 2 475 476 B1**
(45) Veröffentlichungstag und Bekanntmachung des Hinweises auf die Patenterteilung: **03.07.2013**
(21) Anmeldenummer: 10745633.7
(22) Anmeldetag: 23.08.2010
(51) Int. Cl.: B21D 39/03, H05K 5/00

(54) **VERFAHREN ZUM VERBINDEN VON GEHÄUSETEILEN**
METHOD FOR CONNECTING HOUSING PARTS
PROCÉDÉ DE RACCORDEMENT DE PARTIES DE BOÎTIER

(30) Priorität: 10.09.2009 DE 102009040915
(43) Veröffentlichungstag der Anmeldung: 18.07.2012
(73) Patentinhaber: Continental Automotive GmbH, 30165 Hannover (DE)
(72) Erfinder: BRANTSCH, Helmut, 85051 Ingolstadt (DE)
(86) Internationale Anmeldenummer: PCT/EP2010/062270
(87) Internationale Veröffentlichungsnummer: WO 2011/029714

(56) Entgegenhaltungen:
- DE-A1- 19 843 834
- DE-A1-102008 030 775
- JP-A- 8 088 482
- JP-A- 2002 271 064

## Beschreibung

Die Erfindung betrifft ein Verfahren zum Verbinden von Gehäuseteilen.

Ferner betrifft die Erfindung ein Gehäuse.

Die Erfindung betrifft ferner ein elektronisches Bauelement.

Darüber hinaus betrifft die Erfindung ein Fahrzeug.

Moderne Kraftfahrzeuge bilden komplexe Systeme von Hardware und Software. In solchen Systemen kommen verschiedenste elektronische Bauelemente zum Einsatz. Diese Bauelemente können unter anderem in Gehäusen untergebracht sein, um sie modular beliebig einzusetzen und auszutauschen. Diese Gehäuse können aus mehreren Teilen bestehen. Bisherige Gehäuseteile wurden beispielsweise durch Schrauben oder Bördeln verbunden. Unter Bördeln versteht man ein rechtwinkliges Aufbiegen des Randes runder oder ovaler Bleche mit einer Bördelmaschine oder von Hand. Diese Verfahren sind zum einen aufwendig, zum anderen wird dazu eine gewisse Menge an Material benötigt, wodurch die Gehäuse größer werden.

Aus der JP 2002 271064 A ist ein Gehäuse mit zwei Gehäuseteilen und einer dazwischen angeordneten Leiterplatte bekannt.

Die DE 198 43 834 A1 beschreibt ein Durchsetzfügeverfahren, bei dem ein erstes Werkstück und ein zweites Werkstück mit flächigen Abschnitten in zumindest teilweiser Überlappung übereinander gelegt und miteinander verbunden werden.

Aus der DE 10 2008 030 775 A1 ist ein Verfahren zur Herstellung einer dichten, formschlüssigen Verbindung zwischen einem Gehäusedeckel und einem Gehäusekörper vorbekannt, wobei die Verbindung in einem einzigen Arbeitsgang mit einem einzigen Werkzeug bewerkstelligt wird.

Die JP 8 088482 A zeigt ein Gehäuse, das aus zwei Gehäuseteilen besteht, zwischen denen eine Leiterplatte eingeklemmt werden kann.

Der Erfindung liegt die Aufgabe zugrunde, Gehäuseteile auf einfache und Material sowie Platz sparende Weise zu verbinden.

Diese Aufgabe wird gelöst durch die Gegenstände der unabhängigen Patentansprüche. Vorteilhafte Ausführungsformen der vorliegenden Erfindung sind in den abhängigen Ansprüchen beschrieben.

Gemäß einem ersten Aspekt der Erfindung wird ein Verfahren zum Verbinden von Gehäuseteilen bereitgestellt, wobei das Verfahren das Fixieren von zumindest zwei Gehäuseteilen, wobei zwischen den Gehäuseteilen eine Leiterplatte anordenbar ist, wobei die Gehäuseteile zumindest in ihren Randbereichen aufeinanderliegend fixiert werden, und das Verbinden der Gehäuseteile in Teilbereichen ihrer Randbereiche mittels Durchsetzfügen aufweist.

Gemäß einem anderen Aspekt der Erfindung wird ein Gehäuse bereitgestellt, wobei das Gehäuse zumindest zwei Gehäuseteile aufweist, die derart ausgestaltet sind, dass zwischen ihnen eine Leiterplatte anordenbar ist, und wobei die Gehäuseteile zumindest in Teilbereichen ihrer Randbereiche mittels Durchsetzfügen verbindbar sind.

Gemäß noch einem anderen Aspekt der Erfindung wird ein elektronisches Bauelement geschaffen, das das oben beschriebene Gehäuse und eine Leiterplatte aufweist.

Gemäß einem weiteren Aspekt der Erfindung wird ein Fahrzeug mit dem beschriebenen elektronischen Bauelement bereitgestellt.

Gemäß einem exemplarischen Ausführungsbeispiel der Erfindung ist ein Verfahren zum Verbinden von Gehäuseteilen geschaffen. Bei diesem Verfahren werden zumindest zwei Gehäuseteile fixiert, wobei zwischen den Gehäuseteilen eine Leiterplatte anordenbar ist, und wobei die Gehäuseteile zumindest in ihren Randbereichen aufeinanderliegend fixiert werden, und die Gehäuseteile in Teilbereichen ihrer Randbereiche mittels Durchsetzfügen verbunden.

Unter Durchsetzfügen wird ein Verfahren zum Verbinden von Blechen ohne Verwendung eines Zusatzwerkstoffes verstanden. Man kann es zu den Fügeverfahren rechnen. Das Durchsetzfügen wird auch Clinchen genannt. Ein Vorteil des Clinchen ist, dass kein Vorlochvorgang durchgeführt wird. Die statischen Festigkeiten können im Bereich von etwa 2/3 bis hin zum 1,5 fachen einer vergleichbaren Punktschweißverbindung liegen. Die Dauerfestigkeit ist aufgrund von fehlender Kerbwirkung (bei nicht schneidenden Verbindungen) und nicht vorhandener Wärmeeinflusszone höher als bei Punktschweißverbindungen. Besonders wenn unterschiedliche Blechstärken verbunden werden müssen, bietet das Clinchen großes Potential. Wenn die Fügerichtung "Dick in Dünn" eingehalten wird sind statische Festigkeiten, die das Anderthalbfache der Festigkeit einer Punktschweißverbindung übersteigen, möglich. Ein weiterer Vorteil ist, dass auch verschiedenartige Materialien und/oder beschichtete Bleche gefügt werden können

Durch das aufeinanderliegen von zumindest Teilbereichen der Gehäuseteile mit dazwischen angeordneter Leiterplatte kann eine spielfreie Fixierung der Leiterplatte in senkrechter Richtung erreicht werden. Des Weiteren können Ausdehnungsmöglichkeiten in waagrechter Richtung gegeben sein.

Ein weiterer Vorteil kann darin bestehen, dass die Gehäuseverbindung durch plastische Verformung nicht nachfedert. Auf den bei Durchsetzfügen oft verwendeten Schieber an der Matrize kann verzichtet werden.

Im Vergleich zu anderen bekannten Verfahren wie Bördeln wird bei diesem Verfahren eine kleinere, platzsparende und kompakte Gehäuseform zum Verbinden benötigt.

Im Weiteren werden bevorzugte Ausführungsformen des Verfahrens beschrieben. Diese gelten auch für das Gehäuse, für das elektronische Bauelement und für das Fahrzeug.

Die Gehäuseteile können Ecken aufweisen und in den Ecken mittels Durchsetzfügen verbunden werden. Durch das Verbinden in den Ecken kann eine gute Stabilität des Verbindens gewährleistet werden. Wenn die Ecken in zwei Richtungen mittels Durchsetzfügen verbunden werden, kann auch eine spielfreie Fixierung in horizontaler Richtung bereitgestellt werden.

Die Gehäuseteile können Kanten aufweisen und zumindest in Teilbereichen der Kanten mittels Durchsetzfügen verbunden werden. Durch die Verbindung an den Kanten kann ebenfalls eine gute Stabilität des Verbindens erreicht werden. Des Weiteren ist eine Kombination möglich, bei der die Gehäuseteile sowohl in den Ecken als auch in Teilbereichen der Kanten miteinander verbunden werden.

Im Weiteren werden bevorzugte Ausführungsformen des Gehäuses beschrieben. Diese gelten auch für das Verfahren, für das elektronische Bauelement und für das Fahrzeug.

Die Gehäuseteile können rechteckförmig sein. Auf diese Weise sind sie besonders gut für die Aufnahme einer rechteckförmigen Leiterplatte geeignet.

Zumindest ein Gehäuseteil kann in einem mittleren Bereich bauchig ausgebildet sein, um die Leiterplatte aufzunehmen. Durch diese Auswölbung kann die Leiterplatte leicht aufgenommen werden. Die Gehäuseteile können auch eine Aussparung aufweisen, durch die ein Stecker mit der Leiterplatte verbunden werden kann.

Die Gehäuseteile können Ecken aufweisen und in den Ecken mittels Durchsetzfügen verbindbar sein. Des Weiteren können die Gehäuseteile Kanten aufweisen und zumindest in Teilbereichen der Kanten durch Durchsetzfügen verbindbar sein. Auf diese Weise kann eine gute Stabilität und Haltbarkeit des Verbindens erreicht werden. Des Weiteren ist eine Kombination von Verbindungen in Ecken und Kanten möglich.

Im Weiteren werden bevorzugte Ausführungsformen des elektronischen Bauelements beschrieben. Diese gelten auch für das Verfahren, für das Gehäuse und für das Fahrzeug.

Das elektronische Bauelement kann jedes beliebige Gerät sein, das eine Abschirmung gegen elektromagnetische Ein-und Abstrahlung (EMV, EMC, EMI,...) und/oder Metallgehäuse zum Abführen von Verlustleistung/Wärme benötigt. Insbesondere kann das elektronische Bauelement ein DC-DC-Konverter sein. Ein DC-DC-Konverter bzw. Wandler wandelt eine konstante Eingangsspannung durch periodisches Schalten um, so dass am Ausgang im arithmetischen Mittel ein anderer Spannungswert entsteht. Dies wird häufig bei Antriebssystemen benötigt.

Das Gehäuse kann ein Blechgehäuse sein. Ein Blechgehäuse kann zur Abschirmung verwendet werden.

Im Weiteren werden zusätzliche Ausgestaltungen des Fahrzeugs beschrieben. Diese gelten auch für das Gehäuse, für das Verfahren und für das elektronische Bauelement.

Das Fahrzeug kann zum Beispiel ein Automobil (zum Beispiel ein Kraftfahrzeug, insbesondere ein Personenkraftfahrzeug oder Lastkraftfahrzeug) sein. Es ist aber auch möglich, das erfindungsgemäße elektronische Bauelement in einem Zug, in einem Luftfahrzeug (zum Beispiel einem Flugzeug, einem Hubschrauber oder einem Zeppelin) oder in einem Schiff zu implementieren.

Es wird darauf hingewiesen, dass Ausführungsformen der Erfindung mit Bezug auf unterschiedliche Erfindungsgegenstände beschrieben wurden. Insbesondere sind einige Ausführungsformen der Erfindung mit Vorrichtungsansprüchen und andere Ausführungsformen der Erfindung mit Verfahrensansprüchen beschrieben. Dem Fachmann wird jedoch bei der Lektüre dieser Anmeldung sofort klar werden, dass, sofern nicht explizit anders angegeben, zusätzlich zu einer Kombination von Merkmalen, die zu einem Typ von Erfindungsgegenstand gehören, auch eine beliebige Kombination von Merkmalen möglich ist, die zu unterschiedlichen Typen von Erfindungsgegenständen gehören.

Weitere Vorteile und Merkmale der vorliegenden Erfindung ergeben sich aus der folgenden beispielhaften Beschreibung derzeit bevorzugter Ausführungsformen. Die einzelnen Figuren der Zeichnung dieser Anmeldung sind lediglich als schematisch und als nicht maßstabsgetreu anzusehen.
Figur 1 zeigt einen schematischen Aufbau eines mittels Durchsetzfügen verbunden Teils des Gehäuses gemäß einem Ausführungsbeispiel der Erfindung.
Figur 2 zeigt eine schematische Ansicht eines Gehäuses gemäß einem Ausführungsbeispiel der Erfindung.
Figur 3 zeigt eine schematische Teilansicht eines Gehäuses gemäß einem Ausführungsbeispiel der Erfindung.
Figur 4 zeigt einen schematischen Aufbau eines mittels Durchsetzfügen verbunden Teils des Gehäuses mit Werkzeugen.

Die Darstellungen in den Figuren sind schematisch und nicht maßstäblich. Gleiche oder ähnliche Komponenten in unterschiedlichen Figuren sind mit gleichen Bezugsziffern versehen.

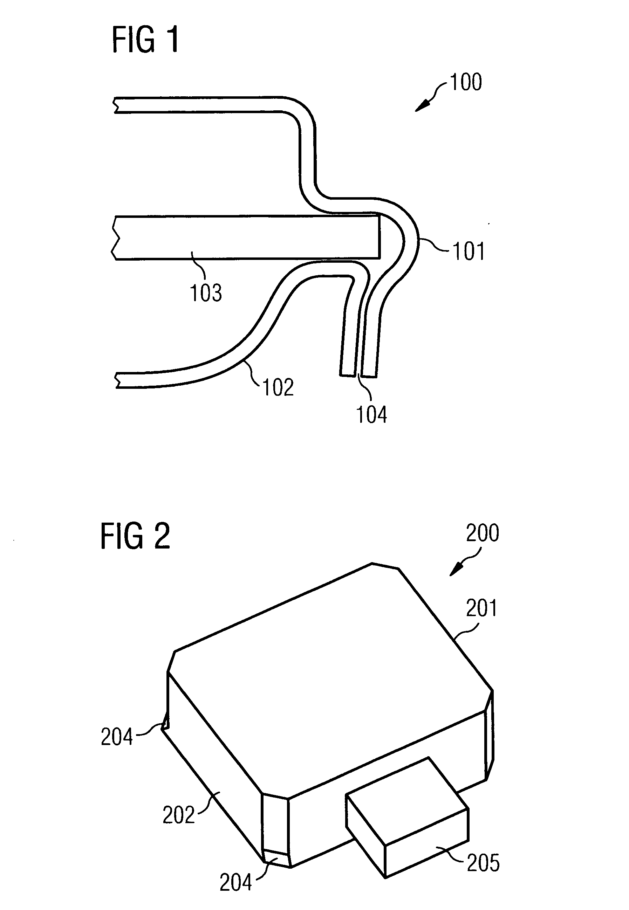

Figur 1 zeigt einen schematischen Aufbau eines mittels Durchsetzfügen verbundenen Teils des Gehäuses 100 gemäß einem Ausführungsbeispiel der Erfindung. Hierbei ist ein erster Gehäuseteil 101 auf einem zweiten Gehäuseteil 102 angeordnet. Zwischen den beiden Gehäuseteilen ist eine Leiterplatte 103 angeordnet. In einem Teilbereich 104 ihrer Randbereiche werden die beiden Gehäuseteile 101 und 102 mittels Durchsetzfügen beziehungsweise Clinchen verbunden. Dabei wird die Leiterplatte 103 zwischen den beiden Gehäuseteilen 101 und 102 fixiert. Auf diese Weise kann die Leiterplatte spielfrei zwischen den Gehäuseteilen fixiert werden.

Figur 2 eine schematische Ansicht eines Gehäuses 200 gemäß einem Ausführungsbeispiel der Erfindung. Das Gehäuse 200 weist einen ersten Gehäuseteil 201 und einen zweiten Gehäuseteil 202 auf. Die beiden Gehäuseteile sind an den Ecken mittels Durchsetzfügen verbunden. Innerhalb des Gehäuses ist eine Leiterplatte angeordnet, auf die über einen Stecker 205 zugegriffen werden kann, der in einer Aussparung des Gehäuses 200 angeordnet ist.

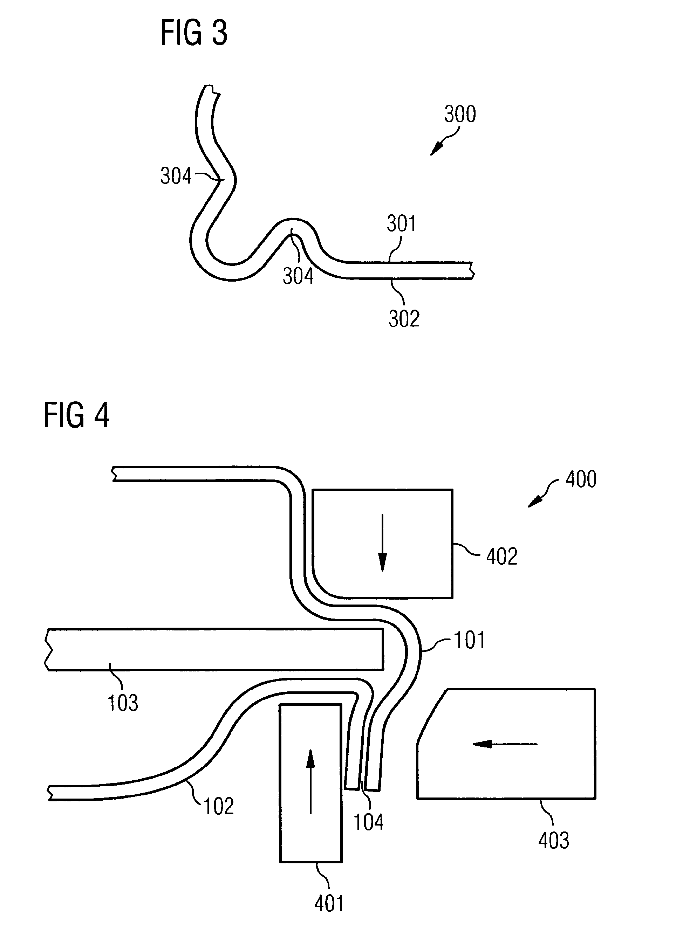

Figur 3 zeigt eine schematische Teilansicht eines Gehäuses 300 gemäß einem Ausführungsbeispiel der Erfindung. Hierbei sind ein erster Gehäuseteil 301 und ein zweiter Gehäuseteil 302 an einer Ecke mittels Durchsetzfügen miteinander verbunden. In diesem Fall sind die Gehäuseteile an der Ecke an zwei Stellen 204 mittels Durchsetzfügen beziehungsweise Clinchen miteinander verbunden. Auf diese Weise kann eine Fixierung der Leiterplatte gut erreicht werden.

Figur 4 zeigt ein weiteres Ausführungsbeispiel der Erfindung mit einen schematischen Aufbau 400 eines mittels Durchsetzfügen verbunden Teils 100 des Gehäuses wie in Figur 1, wobei zusätzlich die Werkzeuge 401, 402, 403 für das Durchsetzfügen dargestellt sind. Die Werkzeuge sind im Einzelnen, eine Matrize 401, ein 402 Niederhalter und ein Druckstempel 403. Wahlweise kann anstelle eines Niederhalters 402 auch eine Klemme verwendet werden. Die Gehäuseteile 101 und 102 werden zwischen dem Niederhalter 402 und der Matrize 401 eingeklemmt. Dabei wird die Leiterplatte 103 zwischen den beiden Gehäuseteilen 101 und 102 fixiert. Auf diese Weise kann die Leiterplatte spielfrei zwischen den Gehäuseteilen fixiert werden. Es ist auch denkbar, die Gehäuseteile 101, 102 ohne Leiterplatte 103 zu fixieren. Nachdem die Gehäuseteile 101, 102 zwischen dem Niederhalter 402 und der Matrize 401 eingeklemmt sind erfolgt ein Umformung der beiden zusammen geklemmten Gehäuseteile 101, 102 in einem Teilbereich 104 durch den Druckstempel 403. In einem Teilstück des Teilbereich 104, bei dem der Druckstempel 104 senkrecht auf die Matrize 401 wirkt werden die Gehäuseteile 101, 102 zusätzlich aneinander gepresst bzw. geprägt, im Idealfall formschlüssig. Es ist auch denkbar, dass der Druckstempel 403 in Druckrichtung eine Prägung aufweist. Ebenso kann die Matrize 401 eine Struktur an der Oberfläche aufweisen, welche dem Druckstempel 403 in Druckrichtung entgegenwirkt, so dass bei der Aneinanderpressung der Gehäuseteile 101, 102 im Teilbereich 104 eine Prägung erfolgt. Dadurch wird eine verbesserte Verbindung der Gehäuseteile 101, 102 erreicht. Die Matrize 401 ist ohne Hinterschnitt ausgebildet. Das hat den Vorteil, dass kein zusätzlicher Schieber zum entfernen der Matrize 401 erforderlich ist.

Es wird darauf hingewiesen, dass die hier beschriebenen Ausführungsformen lediglich eine beschränkte Auswahl an möglichen Ausführungsvarianten der Erfindung darstellen. So ist es möglich, die Merkmale einzelner Ausführungsformen in geeigneter Weise miteinander zu kombinieren, so dass für den Fachmann mit den hier expliziten Ausführungsvarianten eine Vielzahl von verschiedenen Ausführungsformen als offensichtlich offenbart anzusehen sind.

## Patentansprüche

1. Verfahren zum Verbinden von Gehäuseteilen (101, 102; 201, 202) für ein elektronische Bauelement und insbesondere für ein Fahrzeug, wobei das Verfahren aufweist
Fixieren von zumindest zwei Gehäuseteilen, wobei zwischen den Gehäuseteilen eine Leiterplatte (103) anordenbar ist, wobei die Gehäuseteile zumindest in ihren Randbereichen aufeinanderliegend fixiert werden, Verbinden der Gehäuseteile in Teilbereichen (104) ihrer Randbereiche mittels Durchsetzfügen.

2. Verfahren nach Anspruch 1, wobei die Gehäuseteile Ecken aufweisen und die Gehäuseteile in den Ecken mittels Durchsetzfügen verbunden werden.

3. Verfahren nach einem der Ansprüche 1 oder 2, wobei die Gehäuseteile Kanten aufweisen und die Gehäuseteile zumindest in Teilbereichen der Kanten mittels Durchsetzfügen verbunden werden.

4. Gehäuse für ein elektronische Bauelement und insbesondere für ein Fahrzeug, wobei das Gehäuse zumindest zwei Gehäuseteile (101, 102; 201, 202) aufweist, die derart ausgestaltet sind, dass zwischen ihnen eine Leiterplatte (103) anordenbar ist, und wobei die Gehäuseteile zumindest in Teilbereichen (104) ihrer Randbereiche mittels Durchsetzfügen verbunden sind.

5. Gehäuse nach Anspruch 1, wobei die Gehäuseteile rechteckförmig sind.

6. Gehäuse nach Anspruch 4 oder 5, wobei zumindest ein Gehäuseteil in einem mittleren Bereich bauchig ausgebildet ist, um die Leiterplatte aufzunehmen.

7. Gehäuse nach einem der Ansprüche 4 bis 6, wobei die Gehäuseteile Ecken aufweisen und in den Ecken mittels Durchsetzfügen verbindbar sind.

8. Gehäuse nach einem der Ansprüche 4 bis 7, wobei die Gehäuseteile Kanten aufweisen und zumindest in Teilbereichen der Kanten durch Durchsetzfügen verbindbar sind.

9. Elektronisches Bauelement aufweisend
ein Gehäuse nach Anspruch 4 bis 8 und
eine Leiterplatte.

10. Elektronisches Bauelement nach Anspruch 9, wobei das elektronische Bauelement ein DC-DC-Konverter ist.

11. Elektronisches Bauelement nach einem der Ansprüche 9 oder 10, wobei das Gehäuse ein Blechgehäuse ist.

12. Fahrzeug mit einem elektronischen Bauelement nach einem der Ansprüche 9 bis 11.

## Claims

1. Method for connecting housing parts (101, 102; 201, 202) for an electronic component and, in particular, for a vehicle, wherein the method comprises
securing at least two housing parts, wherein a printed circuit board (103) can be arranged between the housing parts, wherein the housing parts are secured one on top of the other at least in their edge regions, and
connecting the housing parts in partial regions (104) of their edge regions by means of clinching.

2. Method according to Claim 1, wherein the housing parts have corners, and the housing parts are connected at the corners by means of clinching.

3. Method according to one of Claims 1 and 2, wherein the housing parts have edges, and the housing parts are connected at least in partial regions of the edges by means of clinching.

4. Housing for an electronic component and, in particular, for a vehicle, wherein the housing has at least two housing parts (101, 102; 201, 202) which are configured in such a way that a printed circuit board (103) can be arranged between them, and wherein the housing parts are connected at least in partial regions (104) of their edge regions by means of clinching.

5. Housing according to Claim 4, wherein the housing parts are rectangular.

6. Housing according to Claim 4 or 5, wherein at least one housing part is constructed with a bulge in a central region in order to accommodate the printed circuit board.

7. Housing according to one of Claims 4 to 6, wherein the housing parts have corners and can be connected at the corners by means of clinching.

8. Housing according to one of Claims 4 to 7, wherein the housing parts have edges and can be connected at least in partial regions of the edges by clinching.

9. Electronic component having a housing according to Claims 4 to 8 and a printed circuit board.

10. Electronic component according to Claim 9, wherein the electronic component is a DC/DC converter.

11. Electronic component according to one of Claims 9 and 10, wherein the housing is a sheet-metal housing.

12. Vehicle having an electronic component according to one of Claims 9 to 11.

## Revendications

1. Procédé pour l'assemblage de parties (101, 102 ; 201, 202) d'un boîtier, lequel procédé présente :
la fixation d'au moins deux parties du boîtier, dans lequel une carte de circuits imprimés (103) peut être agencée entre les parties du boîtier, dans lequel les parties du boîtier sont fixées superposées les unes sur les autres au moins dans leurs zones de bordure,
l'assemblage par clinchage des parties du boîtier dans des zones partielles (104) de leurs zones de bordure.

2. Procédé selon la revendication 1, dans lequel les parties du boîtier présentent des coins et les parties du boîtier sont assemblées par clinchage dans les coins.

3. Procédé selon l'une quelconque des revendications 1 ou 2, dans lequel les parties du boîtier présentent des bords et les parties du boîtier sont assemblées par clinchage au moins dans des zones partielles des bords.

4. Boîtier pour un composant électronique et en particulier pour un véhicule, dans lequel le boîtier présente au moins deux parties (101, 102 ; 201, 202) de boîtier qui sont configurées de telle sorte qu'une carte de circuits imprimés (103) peut être agencée entre elles, et dans lequel les parties du boîtier sont assemblées par clinchage au moins dans des zones partielles (104) de leurs zones de bordure.

5. Boîtier selon la revendication 1, dans lequel les parties du boîtier sont rectangulaires.

6. Boîtier selon la revendication 4 ou 5, dans lequel au moins une partie du boîtier est bombée dans une zone centrale pour recevoir la carte de circuits imprimés.

7. Boîtier selon l'une quelconque des revendications 4 à 6, dans lequel les parties du boîtier présentent des coins et peuvent être assemblées par clinchage dans les coins.

8. Boîtier selon l'une quelconque des revendications 4 à 7, dans lequel les parties du boîtier présentent des bords et peuvent être assemblées par clinchage au moins dans des zones partielles des bords.

9. Composant électronique présentant un boîtier selon la revendication 4 à 8 et une carte de circuits imprimés.

10. Composant électronique selon la revendication 9, lequel composant électronique est un convertisseur CC/CC.

11. Composant électronique selon l'une quelconque des revendications 9 ou 10, dans lequel le boîtier est un boîtier en tôle.

12. Véhicule doté d'un composant électronique selon l'une quelconque des revendications 9 à 11.
